(19) Europäisches Patentamt

European Patent Office

Office européen des brevets

(11) **EP 0 802 633 B1**

(12) **EUROPEAN PATENT SPECIFICATION**

(45) Date of publication and mention
of the grant of the patent:
**30.07.2003 Bulletin 2003/31**

(51) Int Cl.[7]: **H03K 19/02**

(21) Application number: **96302648.9**

(22) Date of filing: **16.04.1996**

(54) **Binary decision diagram (BDD) logic device**

Logische Vorrichtung nach einem binären Entscheidungsdiagramm

Circuit logique selon un diagramme de décision binaire

(84) Designated Contracting States:
**DE FR GB**

(43) Date of publication of application:
**22.10.1997 Bulletin 1997/43**

(73) Proprietor: **HITACHI EUROPE LIMITED
Maidenhead, Berkshire, SL6 8YA (GB)**

(72) Inventor: **Nakazato, Kazuo
Cambridge, CB1 4PA (GB)**

(74) Representative: **Read, Matthew Charles et al
Venner Shipley & Co.
20 Little Britain
London EC1A 7DH (GB)**

(56) References cited:
- **JOURNAL OF APPLIED PHYSICS, vol. 72, no. 9, 1 November 1992, pages 4399-4413, XP000315847 TUCKER J R: "COMPLEMENTARY DIGITAL LOGIC BASED ON THE "COULOMB BLOCKADE""**
- **IEEE TRANSACTIONS ON COMPUTERS, vol. c-27, no. 6, June 1978, NEW YORK, pages 509-516, XP000579877 S.B.AKERS: "binary decision diagrams"**

**Description**

This invention relates to a binary decision diagram (BDD) logic device.

Binary decision diagram (BDD) logic is now commonly used to construct large scale integrated (LSI) circuits. Transistor logic circuits based on BDD architecture have several advantages as compared with the usual AND/OR combinational circuits: higher packing density, lower power consumption, and higher speed. See, for example, K Yano, Y Sasaki, K Rikino and K Seki, IEEE 1994 Custom Integrated Circuits Conference, p. 603.

A binary decision diagram represents a digital function as a directed acylic graph with each node labelled by a variable. It provides a complete and concise representation for most digital functions encountered in logic-design applications. For details, reference is directed to S. B. Akers, "Binary decision diagrams," IEEE Trans. Comput., vol. C-27, no. 6, p. 509, 1978, and R. E. Bryant, "Graph-based algorithm for Boolean function manipulation," IEEE Trans. Comput., vol. C-35, no. 8, p.677, 1986.

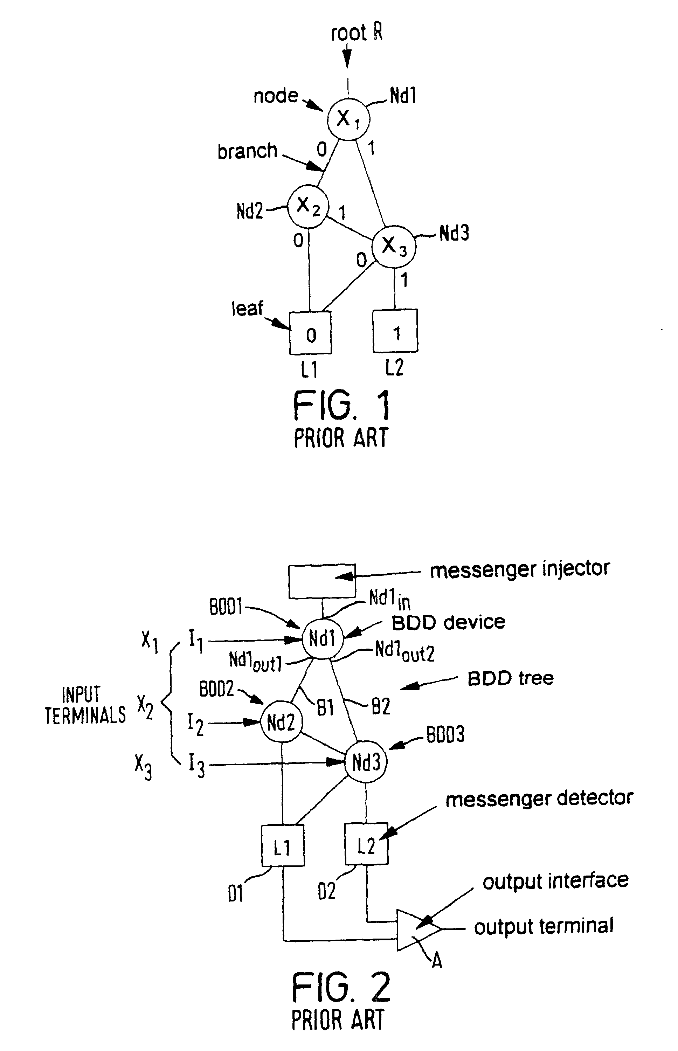

As an example, a three-variable digital function represented by the Boolean equation, $(X_1 + X_2) X_3$ will be considered. This function can be represented by the BDD in Figure 1. A BDD is a graph composed of many nodes $Nd_i$ and two leaves $L_i$. In the Figure 1 each node is represented by a circle Nd containing the variable $X_1$, $X_2$, $X_3$ with two branches B labelled 0 and 1, and leaf $L_1$ and $L_2$ is represented by a square containing the value "0" or "1". In determining the value of the function, the diagram is entered at the root R and proceeded through downward to a leaf L. At each node Nd, the branch corresponding to the value of the variable is followed, namely, the branch B labelled 0 is followed if $X_i = 0$ and the branch labelled 1 is followed if $X_i = 1$. For a given set of variables there is only one path from the root to a leaf of "0" or "1." The value of the function is equal to the value of the leaf at the end of the path: the function is 0 if the end is a "0" leaf, and it is 1 if the end is a "1" leaf.

Most digital systems contain multiple output functions that are closely related, and these functions can be represented as a single diagram with multiple roots. The ordering of the variables influences the size of a diagram, and several methods for determining the optimum ordering to minimise the diagram's size have been developed. BDD's corresponding to a combinational logic circuit with several thousand gates have already been designed, and still more complex BDD's are being developed.

Figure 2 shows an example of a simple BDD logic device which makes use of the decision diagram shown in Figure 1. The three binary input signals $X_1$-$X_3$ are fed on input terminals $I_1 = I_3$ to BDD switching nodes Nd1 - Nd3 respectively. Each node has an input and first and second outputs that are connected to first and second branches respectively. Thus, considering node Nd1 as an example, it has an input $Nd1_{in}$ and outputs $Nd1_{out1}$, $Nd1_{out2}$ that are connected to first and second branches B1, B2 respectively. The nodes Nd2 and Nd3 have a corresponding architecture with the branches being connected as shown. As previously explained, when an input set of variables $X_1$, $X_2$, $X_3$ are applied to the nodes Nd1, Nd2, Nd3, a path through the BDD logic device can be traced from the root R to a leaf L. In the device of Figure 2, a signal travels along the path and reaches a "0" or "1" leaf and the value of the function is determined by detecting which leaf the signals reaches. The signal is referred to hereafter as a messenger signal and is injected into the device by an injector at the root R shown in Figure 2.

Each of the nodes Nd1, Nd2, Nd3 includes a BDD switching device BDD1-3, which switches the messenger signal between the branches connected to the node output according to the state of the input signal $X_i$. Detector circuits D1, D2 are disposed at the leaves L1, L2 in order to detect the messenger signal. An amplifier in the form of a comparator A provides a final output. It will be understood that many different BDD trees can be constructed using the BDD devices such as BDD1 in a suitable cascade of nodes Ndi coupled between the root R and the leaves L.

In the past, the switching nodes have been implemented with transistors but with large cascades of BDD devices, the transistors can take up a significant amount of space even on an LSI circuit and can consume considerable levels of power.

The present invention provides an improved BDD logic device which overcomes these problems.

In accordance with the invention there is provided a BDD logic device including means defining a root, leaves to provide data outputs, branches to convey messenger signals from the root to the leaves, and at least one node for switching signals between first and second ones of the branches selectively in dependence upon applied input signals, the node being adapted to receive electrical charge to a level limited by Coulomb blockade, potential barrier means coupled between the node and the first and second branches respectively, clocking means to provide a clocking waveform that causes charge carrier tunnelling between the node and the first or second branches, and means for altering the relative levels of the potential barrier means selectively in dependence upon the applied control signals whereby to cause charge carriers preferentially to tunnel between the first or the second branch and the node selectively.

The present invention permits the nodes in the BDD logic device to be constructed on a nanometre scale so that the messenger signals may comprise individual or small numbers of charge carriers e.g. electrons. This arises because the node is adapted to receive charge at a level limited by Coulomb blockade. The principle of Coulomb blockade will now be described. For a nanofabricated island, if one electron is added to the island, the charging energy will increase. Consequently, an electron cannot enter the island when the charging energy is larger than the thermal energy. This is known as Coulomb blockade. Using this effect, Fulton and Dolan [T. A. Fulton and G. J. Dolan, Phys. Rev. Lett. 59 (1987) 109] demonstrated a single electron transistor in which the gate voltage controls the successive flow of single electrons. Geerligs et al. demonstrated the transfer of electrons one by one [ L. J. Geerligs, V. F., Anderegg, P. A. M. Holweg, J. E. Mooij, H. Pothier, D. Esteve, C. Urbina and M. H. Devoret, Phys. Rev. Lett. 64 (1990) 2691], synchronised with an external alternating gate voltage. For the static-confinement of discrete numbers of electrons, a single-electron box with one stable state [P. Lafarge, H. Pothier, E. R. Williams, D. Esteve, C. Urbina and M. H. Devoret, Z. Phys. B85 (1991) 327] and a single electron memory with several stable states [K. Nakazato, R. J. Blaikie, J. R. A. Cleaver and H. Ahmed, Electron. Lett. 29 (1993) ' 384 and PCT/GB93/02581] have also been demonstrated. _

In our EP-A-0 562 751, there is described a device in which a plurality of storage nodes are provided, which exhibit first and second stable storage states, in which electron transport to each node is through series connected tunnel junctions devices and limited by Coulomb blockade. A clocking system is provided to control the switching between electron states between each node. The concept of bistable or internal memory at a node, achieved by a series connected capacitance and a series of tunnel junctions or a multiple tunnel junction (MTJ) device is discussed in Averin D.V., and Likharev K. K., "Possible Applications of Single Charge Tunnelling" in H. Grabert and M. H. Devoret "Single Charge Tunnelling" (Plenum Press, New York, 1992) pp 311-332.

Preferably, the potential barrier means between the node and the two branches comprise multiple tunnel barrier configurations. They may be provided with side gates. The input signals may be applied to the side gates.

The or each tunnel barrier configuration may include a conductive channel that has been formed from a $\delta$-doped layer in a substrate, the channel including a region of restricted width which exhibits the characteristics of a multiple tunnel junction. The side gate may comprise a conductive track that overlies the conductive channel.

In order that the invention may be more fully understood, embodiments there of will now be described by way of example with reference to the accompanying drawings, in which:

Figure 1 is a schematic diagram of a conventional BDD logic tree;
Figure 2 illustrates the architecture of a conventional BDD logic device;
Figure 3 is a schematic circuit diagram of a BDD logic device in accordance with the invention;

Figure 4 is a circuit diagram for explaining the characteristics of a MTJ;
Figure 5 is a graph illustrating the hysteresis of the circuit of Figure 4;
Figure 6 is a graph of the voltage of node 2 versus electron flow, for the logic element shown in Figure 3;
Figure 7 is an enlarged schematic perspective view of a MTJ structure formed in a $\delta$-doped layer;
Figure 8 is an enlarged view of the energy distribution in the constricted region of Figure 7;
Figure 9 is a graph of the currents flowing through MTJs 2 and 3 of Figure 3 as a function of $V_2$, with $V_3$ set to zero;
Figure 10 illustrates an embodiment of BDD according to the invention, using MTJs;
Figure 11 illustrates the form of the input signals used in Figure 10;
Figure 12 illustrates the clocking waveform $\phi$, used in Figure 10;
Figure 13 illustrates the phase relationship of the clocking waveforms $\phi_1$, $\phi_2$, $\phi_3$ and $\phi_4$;
Figure 14 is a circuit diagram of an alternative form of the BDD tree shown in Figure 10;
Figure 15 illustrates one form of output configuration for use with a MTJ BDD tree;
Figure 16 illustrates an alternative form of output configuration;
Figure 17 is a schematic perspective view of another embodiment of MTJ, with an overlying side gate;
Figures 18a-e illustrate process steps for fabricating the MTJ shown in figure 17, and
Figure 19 is an electron micrograph of an example of the MTJ shown in Figure 17.

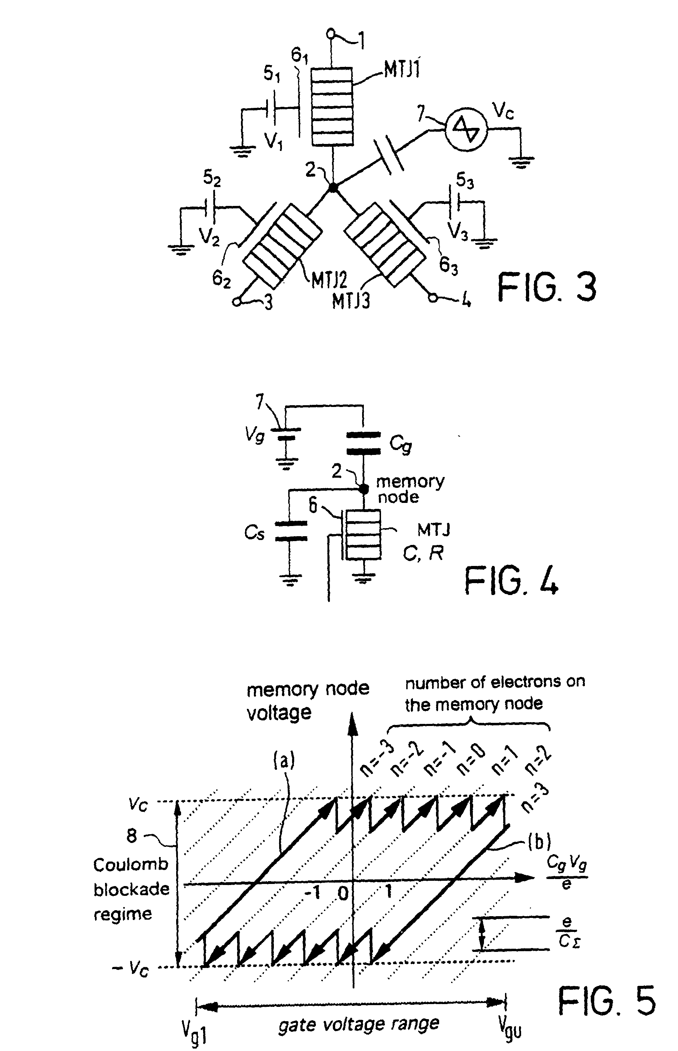

Referring to Figure 3, this illustrates a configuration that is used according to the invention in a BDD node for use in a BDD logic tree e.g. as shown in Figure 2. The node configuration includes an input 1 for the messenger signal, a node 2 and output connections 3, 4 for connection to first and second of the branches of the BDD logic tree. Multiple tunnel junctions devices MTJ1, 2, 3 are connected between the terminals 1, 3 and 4, to the node 2, as shown. Each of the multiple tunnel junction devices receives a bias voltage $V_i$ from a voltage source 5, that is applied to a side gate 6. Thus, for MTJs 2, 3 their gates $6_2$, $6_3$ respectively receive side gate voltages $V_2$, $V_3$.

A clocking voltage $V_c$, from a source 7 is applied through a capacitance $C_g$ to the node 2.

As will be explained in more detail hereinafter, during a first half cycle of the clocking waveform, a messenger signal which comprises one or a small group of electrons e.g. <10, tunnels through the barrier configuration of MTJ1 to the node 2. A precise number of electrons tunnels through the configuration due to the fact that the charge that can be achieved at node 2 is limited by the Coulomb blockade effect. During the next half cycle of the clocking waveform, electrons which form the messenger signal are caused to tunnel out of the node 2 either to terminal 3 or terminal 4 through the barrier configurations of MTJ2 or 3. The route selected depends on the relative values of the side gate voltages $V_2$, $V_3$.

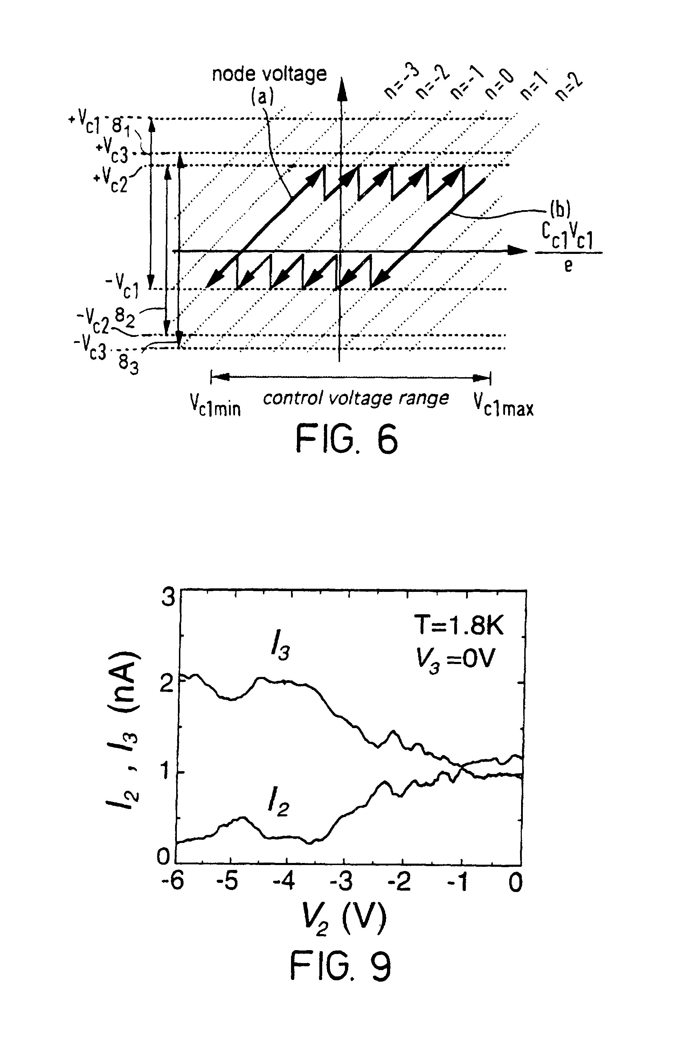

The structure of the multiple tunnel junction devices will now be considered in more detail. As used herein, the term multiple tunnel junction device (MTJ) means a device with more than two series connected tunnelling junctions. The detailed structure of a MTJ will now be considered with reference to Figures 4 and 5 in order to explain its characteristics. Considering the MTJ shown in Figure 4, connected to the node 2, the passage of single electrons through the MTJ is prevent by Coulomb blockade when the modulus of the charge Q on one side of the device is less than a critical charge $Q_c$ i.e. when $-Q_c < Q < Q_c$ where the critical charge $Q_c$ is given by

$$Qc = \frac{eC}{\Sigma C} \frac{(1+\Delta)}{2} \qquad (1)$$

Here $\Sigma C$ is the total capacitance $C + C_g + C_s$, where C is the capacitance of the MTJ, Cg is the gate capacitance, and $C_s$ is the stray capacitance; $\Delta$ determines a multi-state condition given by

$$\Delta = \frac{(N-1)}{N} \frac{(C_g + C_5)}{C} \qquad (2)$$

where N is the number of tunnel junctions in the MTJ. The voltage V at the node 2 is given by

$$v = \frac{e}{\Sigma C} \left( \frac{C_g V_g}{e} - n \right) \qquad (3)$$

where n is the number of excess electrons on the node.
Equation (3) is plotted in Figure 5 and consists of a series of parallel lines for different values of n, shown in dotted outline. Within a Coulomb Blockade regime, $-Q_c/C < V < Q_c/C$, electrons cannot enter or exit the memory node 2 and the upper and lower limits of the voltage $\pm V_c$ of the memory node 2 that are set by Coulomb Blockade, corresponding to $\pm Q_c/C$, are shown by chain lines in Figure 5. When V reaches the boundary of this Coulomb Blockade regime, one electron enters or leaves to keep the energy of the node 2 inside the Coulomb Blockage regime. By applying a gate-voltage pulse $V_g$ with magnitude larger than $e\Delta/C_g$, the number of electrons on the node 2 can be changed as will be explained in more detail hereinafter.
The resulting characteristic exhibits hysteresis and is represented by the solid line shown in Figure 5. Considering when the gate voltage is increased from the lowest value $V_{g1}$ of the range shown in Figure 5, the characteristic moves along line (a) for which n=-3 (a shortfall of 3 electrons at the node 2) until the voltage of node 2 reaches the Coulomb Blockade limit $V_c = Q_c/C$. The node 2 then gains an electron by virtue of the Coulomb Blockade effect, so the characteristic jumps to the line for n=-2, since the node voltage V is limited by Coulomb Blockade. As the gate voltage is progressively increased to $V_{gu}$, its upper value, the electron state of the memory node progressively increases stepwise until a surplus of 3 electrons becomes established on the node 2, i.e. n= 3. If the gate voltage $V_g$ is then decreased , the voltage at memory node 2 decreases along line (b) for n= 3, until the lower Coulomb Blockade limit $-V_c = -Q_c/C$ is reached, whereafter the electron state of the node changes stepwise to n=-3 as the gate voltage is reduced to its lower limit $V_{gl}$.
When the gate voltage $V_g$ is at zero, the node 2 can thus assume one of two stable states, for which, as shown in Figure 5, in this example, n= $\pm 2$, and this can be used as a memory.
In general, one bit of information can be represented by + n and - n electron number states, where n is given by the integer part of $(\Delta+1)/2$. If the capacitances are chosen to satisfy the condition $\Delta<1$, a binary code can be represented by the presence or absence of one electron. For further details, reference is directed to our PCT/GB93/02581.
The effect of applying a side gate voltage to the side gate 6 in Figure 4 will now be described. From Figure 5, it will be seen that Coulomb blockade occurs between a memory node voltage of $+V_c$ and $-V_c$. The effect of the side gate voltage is to modify the value of the Coulomb blockade voltage $V_c$. Thus, referring to Figure 5, the range 8 of voltage in which Coulomb blockade can be varied by varying the side gate voltage applied to the side gate 6 shown in Figure 4. For further details, reference is directed to PCT/GB93/02581 *supra*.
Referring now to Figure 6, the disposition of the Coulomb blockade voltage regions $8_1$, $8_2$ and $8_3$ for MTJ1, MTJ2 and MTJ3, is shown in respect of the circuit configuration shown in Figure 3. It will be understood that a clocking voltage $V_{c1}$ is applied to the node 2, which, as shown in Figure 6, varies between a minimum value of $V_{c1\ min}$ and a maximum value of $V_{c1\ max}$.
In operation, when the clocking voltage $V_{c1}$ is reduced from its maximum value towards to its minimum value, the characteristic shown in Figure 6 moves downwardly along line b until the limit of Coulomb blockade for MTJ1 is reached namely $-V_{C1}$. As the clocking voltage is reduced further, electrons tunnel through the multiple tunnel junction barrier of MTJ1 so that the electron state at node 2 changes from n= 2 to n=-3 as a result of successive electron tunnelling through the barrier, until the clocking voltage reaches its minimum value $V_{c1\ min}$. When the clocking voltage increases, the characteristic moves along line (a) for the condition in which n=-3. This continues until a Coulomb blockade limit is reached. In this example, the limit is set by the Coulomb blockade limit voltage for MTJ2, namely +$V_{c2}$. When the characteristic shown as line (a) reaches +$V_{c2}$, an electron tunnels through the barrier presented by MTJ2 and the characteristic jumps to a condition n=-2, and as the clocking voltage $V_{c1}$ increases, further electron tunnelling is occurs until the condition n=2 is reached. Thus, electrons from node 2 tunnel through MTJ2 and pass to terminal 3 shown in Figure 3.

As previously explained, the Coulomb blockade voltage +$V_{c2}$ and the corresponding voltage +$V_{c3}$ are set by means of the side gate voltages $V_2$ and $V_3$ for the MTJs respectively. It can therefore be seen that by suitably adjusting the side gate voltages, the level +$V_{c3}$ can be made <$V_{c2}$, in which case electrons would tunnel preferentially through the barrier of MTJ3 to the terminal 4, rather than through MTJ2 to terminal 3. Thus, electrons can tunnel either to terminal 2 or 3 depending on the settings of the side gate voltages $V_2$ and $V_3$. Furthermore, it will be understood that the number of electrons that tunnel for each cycle of clocking voltage is determined by the voltage excursion of $V_{c1}$. The device thus operates as a turnstile in which a fixed number of electrons transfers to and from the node 2 for each cycle of clocking voltage. In this example, 6 electrons are transferred to and from the node for each cycle.

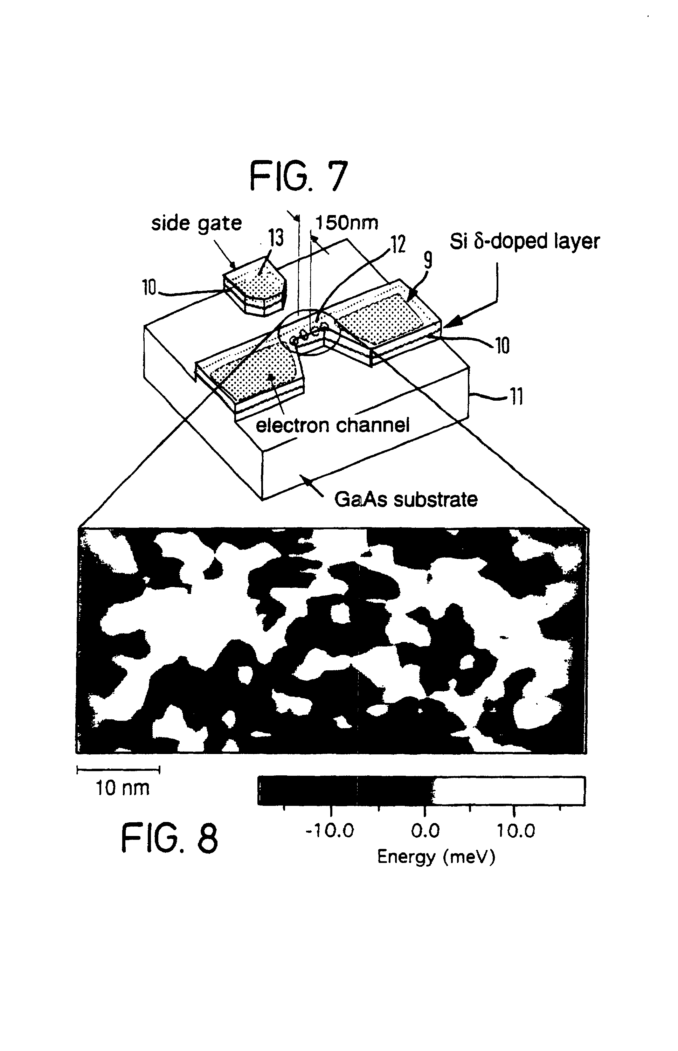

The structure of the MTJ will now be described. In order to utilise the Coulomb Blockade effect, the structures must be made sufficiently small to make the charging energy larger than their thermal energy; the charging energy is proportional roughly inversely to the linear dimension. To realise a suitable very small structure, a side-gate structure in δ-doped GaAs material may be used, as shown in Figure 7. An elongate electron channel 9 is formed in a δ-doped layer 10 which is situated 30 nm below the surface of a GaAs substrate 11 and is a few atomic layers in thickness. The layer 9 is typically doped with Si to a concentration of 5 x $10^{12}$ cm$^{-2}$ and the various layers are grown by molecular beam epitaxy (MBE) or metalorganic chemical vapour deposition (MOCVD) techniques. In both processes, the thickness of the dopant layer can be introduced into only one atomic layer, and the resulting material is said to be δ-doped. [Nakazato, K., Thornton, T.J., White, J., and Ahmed, H.: "Single-electron effects in a point contact using a side-gating in delta-doped layers", Appl. Phys. Lett., 1992, 61, 3145]. A fine side-gated constriction 12 with a spaced side gate 13 is defined by electron beam lithography and wet etching to a depth of 120 nm to form the MTJ. The resistance of the junction is controllable since the application of a negative voltage to the side gate 13 changes the electron Fermi energy and repels the electrons from the edge of the electron channel.

As a specific example of the process parameters, the MTJ was formed by an etched constriction with a mask width of 500 nm and length of 200 nm. The mask width at the narrowest part (i.e. side-gate to channel separation) was 150 nm. The pattern was defined by electron beam (EB) lithography and wetetching. The EB exposure was performed on a 150 nm thick polymethylmetacrylate (PMMA) coated on the δ-doped GaAs wafer. After exposure, a 30 sec development process with a weak developer (methylisobutyl-ketone : isopropyl-alcohol = 1:5) was made in order to develop only the strongly exposed regions. After 20 sec $O_2$ plasma etch to remove residual resist, the δ-doped GaAs layers were etched using an $H_3PO_4$: $H_2O_2$ : $H_2O$ = 1:2 : 40 solution. The depth of the trench was controlled to 120 nm by adjusting the etch-time.

The total capacitance C of the MTJ is estimated to be 5 aF from the observed Coulomb gap voltage e/ 2C ∼ 15 mV. This characteristic can be explained by postulating a series of micro-segments split by potentials of donor atoms and forming a series of single-electron transistors. The formation of several islands is supported by another measurement in the highly pinched-off region of operation in that negative resistance due to resonant tunnelling among microsegments has been observed, and by the calculation of conductance modelled using standard single-particle recursive Green's function techniques [R. J. Blaikie, K. Nakazato, R. B. S. Oakeshott, J. R. A. Cleaver and H. Ahmed, Appl. Phys. Lett. 64 (1994) 118]. The calculated potential landscape within a constriction 60 nm long and 30 nm wide is shown in Fig. 8. There are large ( ∼ 30 meV) potential fluctuations within the channel, and more than 5 potential wells are evident for the random impurity configuration used for this simulation.

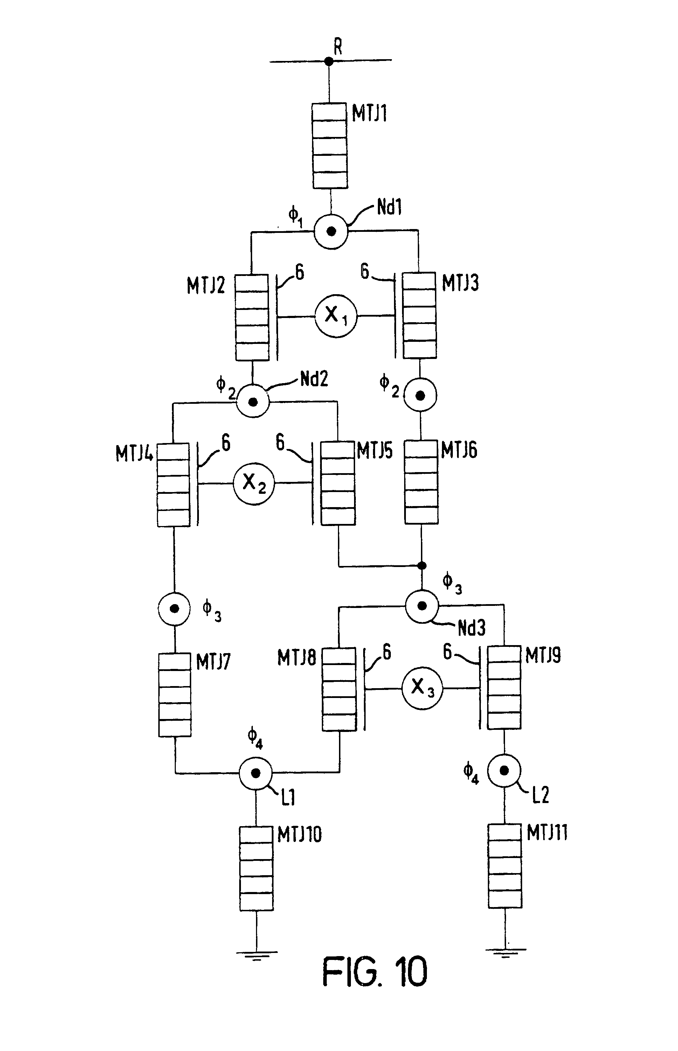

A test chip has been constructed consisting of a BDD logic element as described with reference to Figure 3, using side gated MTJs in a δ-doped layer. Clear switching characteristics have been obtained as shown in Figure 9, where a 6 MHz rf signal was applied as a clocking waveform $V_{c1}$ to the node 2 shown in Figure 3. Currents $I_2$ and $I_3$ through MTJ2 and MTJ3 respectively were measured with a voltage of 10 mV across the logic element. The gate voltage $V_3$ was fixed at zero. When the gate voltage $V_2$ was set at zero, electrons flowed equally through MTJ2 and MTJ3. When $V_2$ was decreased, the Coulomb blockade region of MTJ2 expanded and electron flow was switched from MTJ2 to MTJ3.

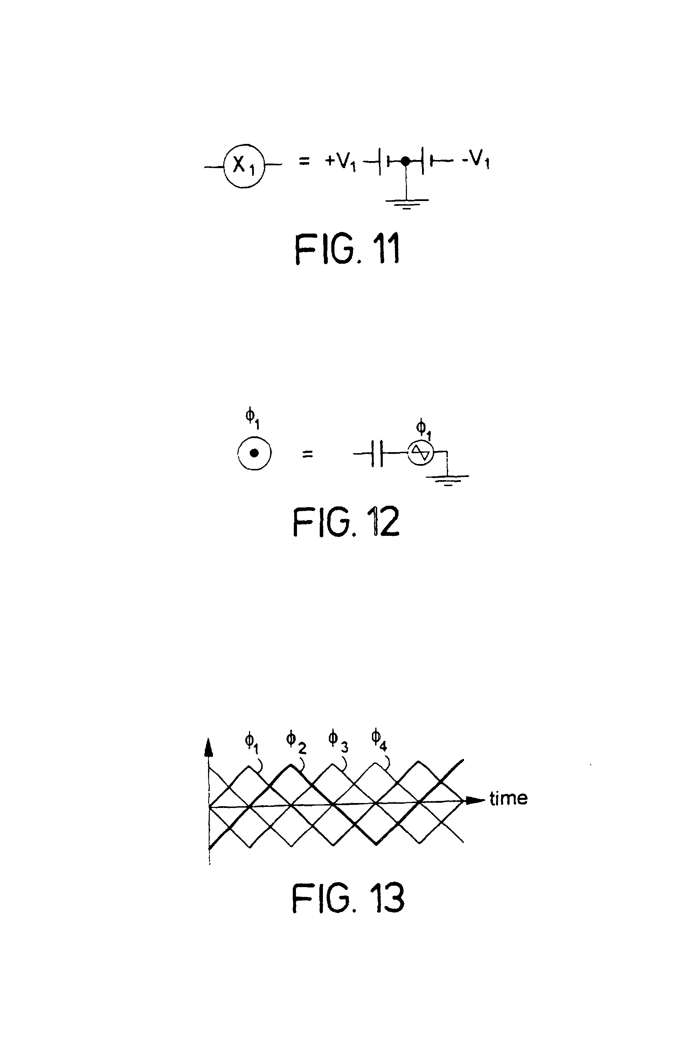

Figure 10 shows an implementation of the logic function ($X_1$ + $X_2$) $X_3$ according to the BDD shown in Figure 1, by means of BDD logic elements that employ MTJs in a manner described with reference to Figure 3. Each input signal X comprises a complimentary pair of voltages ± V as shown in Figure 11. Thus, for node Nd1, the input signal $X_1$ is applied to the side gates 6 of MTJ2 and MTJ3. Similarly, for node Nd2, the input signal $X_2$ is applied to the side gates of MTJ4 and MTJ5 respectively. Clocking waveforms φ are applied to various points in the circuit as shown in Figure 12. The clocking waveform is generated as shown schematically in Figure 13. Four clocking waveforms φ$_1$ - φ$_4$ are applied, which have respective phase differences as shown in Figure 13. Thus, considering the node Nd1, clocking waveform φ$_1$ causes discrete packets for electrons to tunnel sequentially through MTJ1 to the node Nd1 and the input signal X1 causes the packets of electrons either to tunnel through MTJ2 or MTJ3 depending on the value (sign) of $X_1$, according to the principles described with previously with reference to Figure 6. It will be noted that MTJ1 does not have a side gate in this example as it is not strictly necessary for operation of the device. Similarly, it will be noted that MTJ6 does not include a side gate. MTJ6 is included to maintain the correct phase relationship between the signals passing through the BDD tree, and MTJ6 cooperates with MTJ3 to operate as a turnstile. Similarly, MTJ7 cooperates with MTJ4 to operate as a turnstile and maintain the correct phase relationship for signals passing through the BDD logic tree.

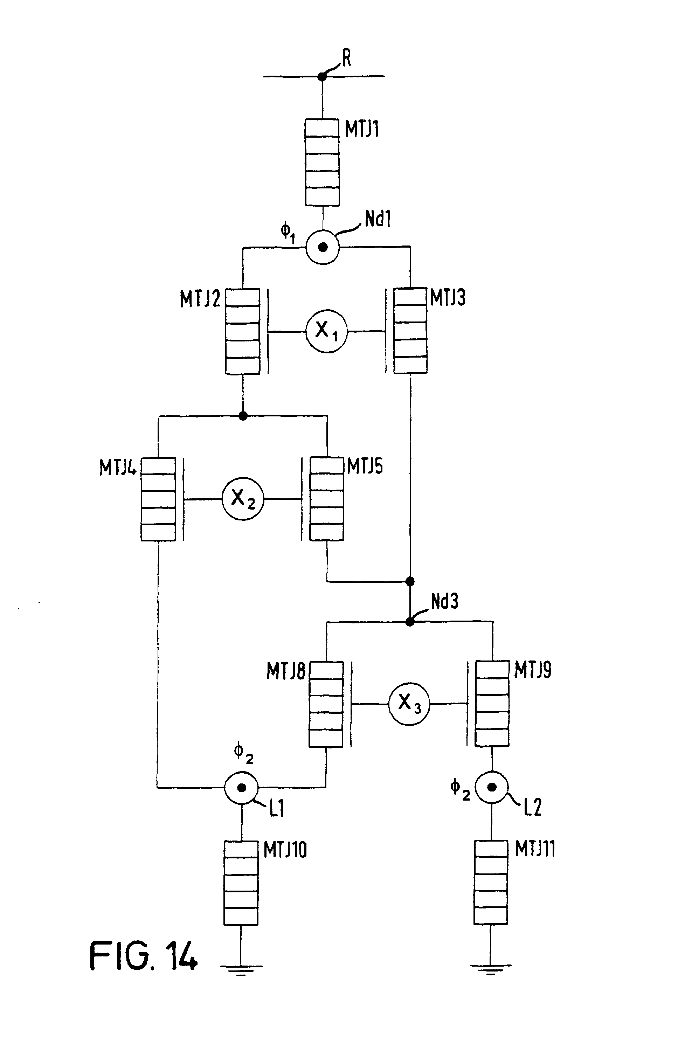

Figure 14 illustrates a modification in which a two-phase clocking regime is used, which permits MTJ6 and 7 to be omitted. This has the advantage of . simplifying the device structure but has the disadvantage of a higher power consumption because the capacitance of each node is higher than in Figure 14 as compared with Figure 10. In practice, a combination of the two-phase and four-phase techniques described with reference to Figures 10 and 14 can be combined in a single circuit.

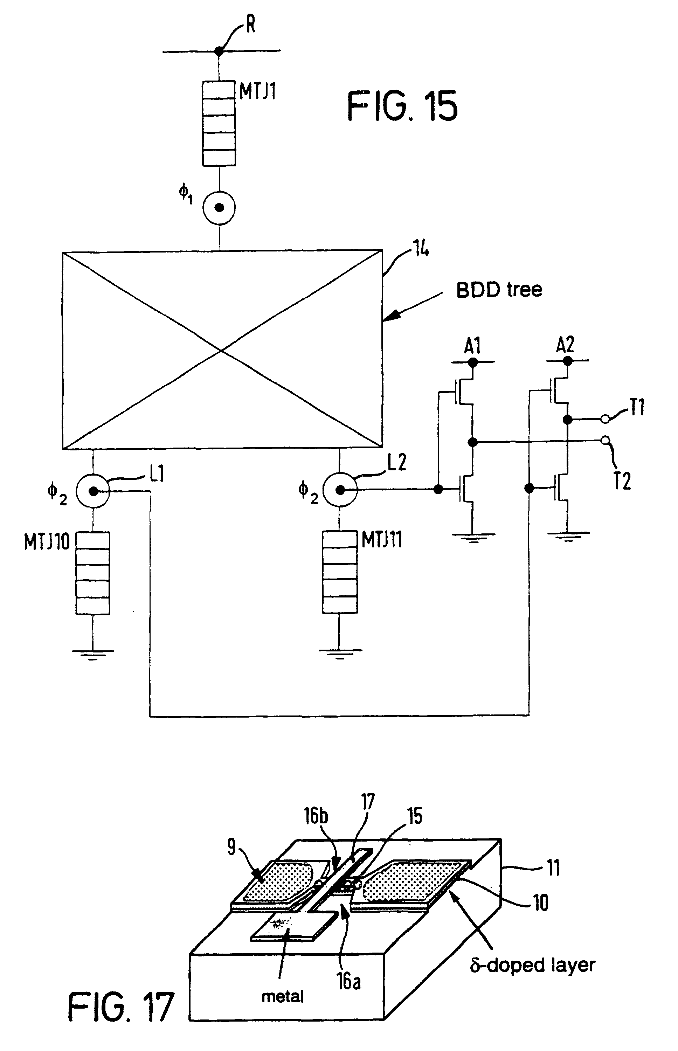

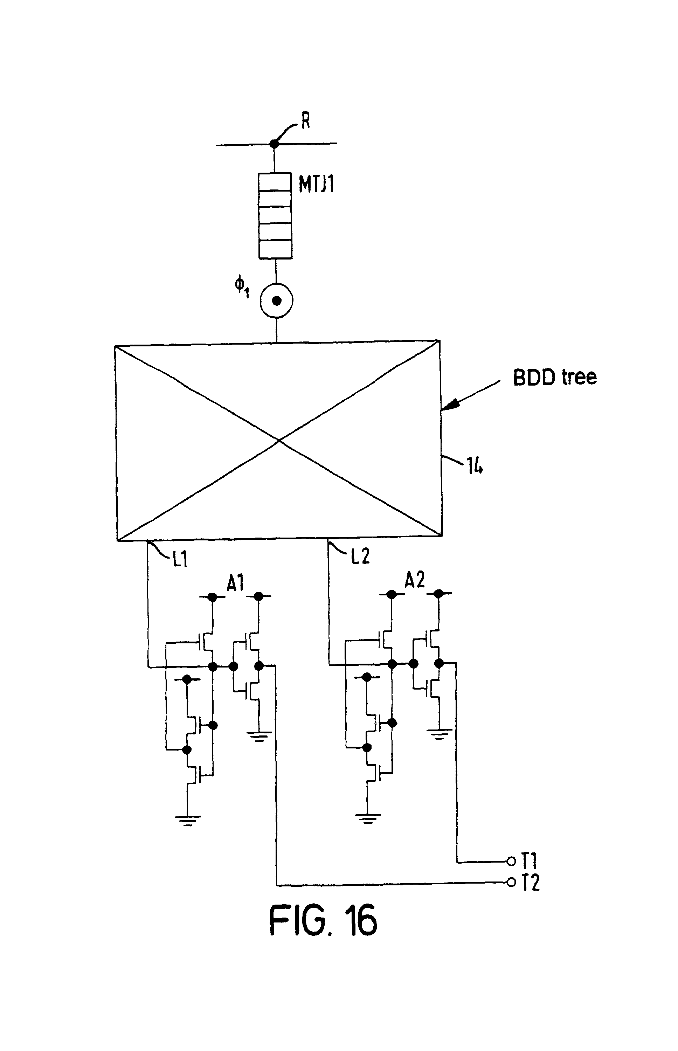

It will be appreciated that a number of the BDD logic circuit elements as shown in Figure 3, can be combined in different ways to achieve different BDD trees. This is shown generally in Figure 15, which can be considered as a modification of the circuit of Figure 14 with the BDD logic tree being shown generally as 14. First and second CMOS inverters A1, A2 are responsive to the electron state of the nodes which constitute the leaves L1, L2 so as to provide a binary conventional voltage output at terminals T1, T2. An alternative configuration of the CMOS inverter output stages A1, A2 is shown in Figure 16. Other output stages can be used for example single-electron transistor or a gated MTJ, instead of the CMOS transistor arrangement.

Whilst satisfactory BDD logic trees can be constructed using side gated MTJs as described with reference to Figures 7 and 8, a disadvantage arises in that the side gate and electron channels for all of the devices are formed in the same plane, from the same δ-doped layer. This has the disadvantage that the circuit configuration needs to be designed so that they various conductive tracks do not overlie one another. For complicated logic circuits it is simpler to use multi-layer interconnections in order to optimise the circuit layout.

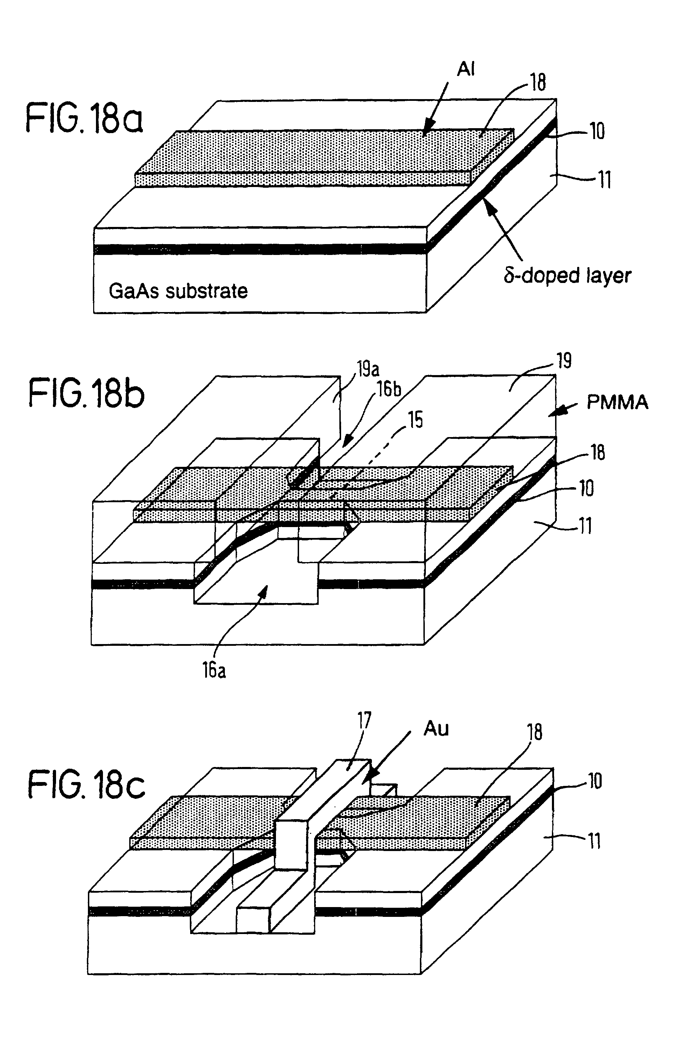

Referring now to Figure 17, an alternative MTJ structure is shown which includes a constriction 15 in a δ-doped layer 10 on a substrate 11, in a conductive track 9 formed according to the principles described with reference to Figure 7. In this example, the constriction 15 is formed by bilateral cutout regions 16a, 16b on opposite sides of the conductor 9. A metallic gate layer 17 so that a voltage applied to the gate produces a functionally similar effect to a voltage applied to the side gate 13 shown in Figure 7.

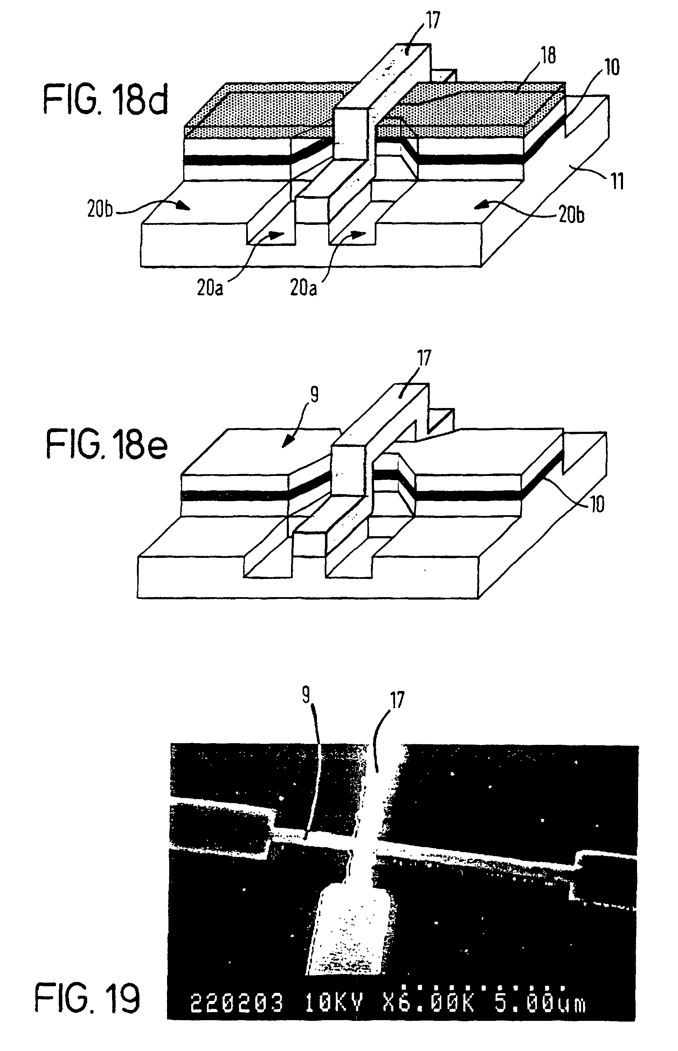

An example of a method of manufacturing the MTJ shown in Figure 17 will now be described with reference to Figure 18. Referring to Figure 18a, the δ-doped layer 10 was grown on the GaAs substrate 11 by MOCVD. The δ-doped layer 10 was formed 30 nm below the surface and was doped with Si to a concentration of $5 \times 10^{12}$ cm$^{-2}$. The carrier concentration is estimated to be $4 \times 10^{12}$ cm$^{-2}$ from Hall resistance measurements made at liquid helium temperatures. After resist patterning by electron beam lithography, aluminium was evaporated onto the substrate to a thickness of 40 nm, and patterned by a lift-off method, to achieve the configuration shown in Figure 18a.

Referring to Figure 18b, a mask 19 of 450 nm thickness PMMA was deposited on the structure and patterned by electron beam lithography to form a transverse track 19a. Then the GaAs substrate 11 was wet etched isotropically through the track 19a to a depth of 120 nm, using citric acid:$H_2O_2$ (6%) = 2:1 solution so as to form the regions 16a, 16b and the corresponding constriction 15 in the δ-doped layer 10.

Gold was evaporated to a thickness of 250 nm and patterned by a lift-off method so as to form the gate electrode 17 as shown in Figure 18c. Then, using the deposited A1 layer 18 and the Au layer 17 as a mask, the GaAs substrate was etched to a depth of 120 nm by a reactive ion etch method in $SiCl_4$ and Ar gases as shown in Figure 18d, removing GaAs from regions 20a, 20b.

Thereafter, the Al layer 18 was removed using MF319 developer and the final structure was formed as shown in Figure 18e. An electron micrograph of a device constructed according to the above described method is shown in Figure 19.

Many modifications and variations of the described examples of the invention are possible. Whilst the described examples make use of side gated MTJs, other single electron devices can be used with the requirement their blocking voltage be alterable in order to produce the selective switching in a manner analogous to the side gate switching function described previously.

A number of different techniques have been employed hitherto in order to realise ultra-small tunnel junctions, which could be used in the BDD logic device according to the invention, including double-angle evaporation of Al [G. J. Dolan, Appl. Phys. Lett. 31 (1977) 337], and Schottky gate confinement of the two-dimensional electron gas (2DEG) formed at the GaAs/AlGaAs heterointerfaces [U. Meirav, M. A. Kastner and S. J. Wind, Phys. Rev. Lett. 65 (1990) 771, and L. P. Kouwenhoven, N. C. van der Vaart, A. T. Johnson, W. Kool, C. J. P. M. Harmans, J. G. Williamson, and A. A. M. Staring, Z. Phys. B - Condensed Matter 85 (1991) 367]. Recently, single-electron effects have been observed in several new semiconductor structures, in-plane gate 2DEG [H. Pothier, J. Weis, R. J. Haug, K. v. Klitzing and K. Ploog, Appl. Phys. Lett. 62 (1993) 3174], silicon-on-insulator (SOI) [D. Ali and H. Ahmed, Appl. Phys. Lett. 64 (1994) 2119], dual-gated Si MOS [H. Matsuoka, T. Ichiguchi, T. Yoshimura and E. Takeda, Appl. Phys. Lett. 64 (1994) 586], and SiGe structures [D. J. Paul, J. R. A. Cleaver, H. Ahmed and T. E. Whall, Appl. Phys. Lett. 63 (1993) 631].

Metallic single electron transistors can also be used in BDD devices according to the invention. They can be made in a variety of ways. The classical approach was to use the Al-$Al_2O_3$-Al structure with the oxide providing the thin tunnel barrier. The problem of achieving a small size as well as accurate alignment was overcome by using a procedure which gives self-aligned structures. A suspended or free-standing bridge of a material is fabricated by electron beam lithographic techniques. An Aluminium film is evaporated at an angle to the bridge and oxidised to form a very thin insulating layer on its surface. A second film evaporated at an angle overlaps the first film by.a few hundred nanometers if the angle is carefully chosen. This gives a metal-insulator-metal junction with a capacitance of the order of 1 fF and the device exhibits clear Coulomb blockade at low temperatures. The shadow evaporation technique has been used successfully by a number of researchers. A chromium structure was fabricated by Yu. A. Pashkin, L. S. Kuzmin, A. N. Tavkhelidze, F.-J. Ahlers, T. Weimann, D. Quenter, and J. Niemeyer, in International Symposium "Nanostructures: Physics and Technology", St. Petersburg, June 1995. Chromium has a small grain structure which gives a low potential barrier with good chemical and thermal stability.

Another method was used by Chen, Ahmed and Nakazato in which a number of ultra-small gold islands were formed by ionised beam evaporation in a small gap between two narrow lines fabricated by high resolution electron beam lithography [W. Chen, H. Ahmed, and K. Nakazato, Appl. Phys. Lett. 66 (1995) 3383]. This reduced the island size and also the junction capacitance very considerably. The structure was made on a $SiO_2$ covered Si substrate. Clear Coulomb blockade was seen at 77K and even at room temperatures a non-linearity in the current-voltage characteristics was clearly observed. Another novel method of making atomic scale metallic islands was designed by Woodham and Ahmed which should enable the reduction of island sizes to the level of 1 nm or less so that room temperature operation of Coulomb blockade based devices may be possible [R. G. Woodham and H. Ahmed, J. Vac. Sci. Technol. B12 (1994) 3280]. In this method a focused ion beam system is used with a retarding field so that gold ions are deposited at a well controlled energy within the range 1 keV to < 100 eV to form ultra-small islands of gold on the substrate. The method has been used to make islands consisting of a few tens of atoms only and is capable of achieving single atom lithography in principle.

Another effective method for making metallic tunnel junctions is to make very thin metallic wires with a discontinuity created by a step coverage break induced by a sharp-edged groove in the substrate. The sharp groove can be created in a $SiO_2$ layer on Si substrate. Clear Coulomb blockade has been seen in such devices [S. Altmeyer, B. Spangenberg, and H. Kurz, Appl. Phys. Lett. 67 (1995) 569, and W. Langheinrich and H. Ahmed, Proceedings of the 1995 International Microprocess Conference].

Single-electron devices can be realised in semiconductor structures by the split-gate method [T. J. Thornton, M. Pepper, H. Ahmed, D. Andrews, and G. J. Davies, Phys. Rev. Lett. 56 (1986) 1198], employing electrostatic squeezing to vary the shape of a two-dimensional electron gas at a GaAs and AlGaAs heterointerface. Meirav et al. fabricated narrow channels interrupted by two controlled potential barriers and having a tuneable electron density [U. Meirav, M. A. Kastner and S. J. Wind, Phys. Rev. Lett. 65 (1990) 771]. Kouwenhoven et al. fabricated a split-gate quantum dot structure in which gate structure allows independent control of the conductances of the two tunnel barriers separating the quantum dot from the two 2DEG leads, and enables the number of electrons localised in the dot to be varied. Field et al. investigated the behaviour of a laterally confined quantum dot in close proximity to a one dimensional channel in a separate electric circuit used as a voltage probe [M. Field, C. G. Smith, M. Pepper, D. A. Ritchie, J. E. F. Frost, G. A. C. Jones, and D. G. Hasko, Phys. Rev. Lett. 70 (1993) 1311].

Although many different materials systems have been used to demonstrate Coulomb blockade, silicon devices are of particular importance because the material is widely used and fabrication processes have been developed for metal-oxide-semiconductor (MOS) transistors that can be readily adapted for single electronics. A device structure showing clear Coulomb blockade effect in silicon-on-insulator (SOI) was first demonstrated by D. Ali and H. Ahmed in Appl. Phys. Lett. 64 (1994) 2119. The silicon island was separated from source and drain contacts by tunnel junctions formed in ultra-thin silicon. When the capacitance of such a structure was reduced the necessary condition $e^2/2C > > k_BT$ was met at near room temperature and single electron characteristics were observed by Y. Takahashi, M. Nagase, H. Namatsu, K. Kurihara, K. Iwdate, Y. Nakajima, S. Horiguchi, K. Murase, and M. Tabe in Electron. Lett. 31 (1995) 136. SOI not only lends itself readily to a variety of fabrication processes which are compatible with future CMOS technologies but allows multiple tunnel junction (MTJ) devices to be made in silicon. Devices were fabricated on a 50 nm thick silicon layer of a silicon-on-insulator substrate formed by separation by implantation of oxygen (SIMOX). The silicon was uniformly doped to above the metal-insulator transition by implanting 1 x $10^{14}$ cm$^{-2}$ of phosphorus at 20 keV and was annealed at 950°C for 30 minutes, initially in an oxidising environment to grow at 25 nm thick oxide cap and minimise loss of dopant. The oxide cap was then removed in buffered HF. Electron beam lithography and dry etching were used to define a very narrow wire in the SOI layer, and tunnel junction regions were defined with a second stage of electron beam lithography, and etching perpendicular to the wire length, without etching all the way through the silicon.

Another silicon based structure was demonstrated by H. Matsuoka, T. Ichiguchi, T. Yoshimura and E. Takeda, in J. Appl. Phys. 76 (1994) 5561. They used a double gate MOS device. One gate was used to control the inversion layer while a second patterned or grating gate was used to form islands and tunnel junctions. Both gates were fabricated by electron beam lithography between source and drain n+ regions with 5 mm separation. The gates were separated by 50 nm thick $SiO_2$.

Thus, all of these known devices can be used to isolate small numbers of electrons, typically less than ten, at a node, and to switch the electrons. to different branches in a BDD logic device according to the invention.

## Claims

1. A binery decision diagram -BDD- logic device including means defining a root (R), leaves (L1, L2) to provide data outputs, branches (B) to convey messenger signals from the root to the leaves, and at least one node (Ndi, 2) for switching signals between first and second ones of the branches (B1, B2) selectively in dependence upon applied input signals (Xi), the node being adapted to receive electrical charge to a level limited by Coulomb blockade, potential barrier means (MTJ, 2, 3) coupled between the node and the first and second branches respectively, clocking means (Vcl) to provide a clocking waveform ($\varphi$1) that causes charge carrier tunnelling between the node (2) and the first or second branches (B1, B2), and means (V2, V3) for altering the relative levels of the potential barrier means selectively in dependence upon the applied control signals whereby to cause charge carriers preferentially to tunnel between the first or the second branch and the node selectively.

2. A device according to claim 1 including a messenger signal input (1) for the node (2) and potential barrier means (MTJ1) between the input and the node.

3. A device according to claim 2 including means (Vcl, Cg) for applying the clocking waveform ($\varphi$1) to the node (2).

4. A device according to any preceding claim including a plurality of BDD logic elements (BDD1) coupled to one another, each of said elements comprising a respective set of two of said branches, an associated said node and potential barrier means between the two branches and the node.

5. A device according to claim 4 including means for applying a plurality of clocking waveforms ($\varphi$1, $\varphi$2, $\varphi$3, $\varphi$4) to the BDD logic elements with a phase difference for causing charge carriers to move from node to node of the logic elements.

6. A device according to any preceding claim wherein the potential barrier means comprise multiple tunnel barrier configurations (MTJ1, MTJ2, MTJ3).

7. A device according to claim 6 wherein the multiple tunnel barrier configurations are provided with side gates (6).

8. A device according to claim 7 including means for applying said input signals (X1, X2, X3) to the side gates (61, 62, 63).

9. A device according to any one of claims 6 to 8 wherein the means providing the tunnel barrier configuration includes a conductive channel (10) that has been formed from a $\delta$ doped layer in a substrate (11), the channel including a region (12, 15) of constricted width which exhibits the characteristics of a multiple tunnel junction.

10. A device according to claim 9 including side gate means (13, 17) adjacent the constricted region.

11. A device according to claim 10 wherein the side gate means comprises a conductive track (17) that overlies the conductive channel.

12. A device according to any preceding claim including output means (A1, A2) coupled to the leaves to provide an output logical signal.

13. A device according to claim 12 wherein the output means comprises an amplifier.

## Patentansprüche

1. Logik-Vorrichtung nach einem binären Entscheidungsdiagramm (BDD) umfassend eine Einrichtung, die eine Wurzel (R), Blätter (L1, L2), um Datenausgaben vorzusehen, Zweige (B), um Botensignale von der Wurzel an die Blätter zu senden, und zumindest einen Knoten (Ndi, 2) zum wahlweisen Schalten von Signalen in Abhängigkeit von angelegten Eingangssignalen (Xi) zwischen einem ersten oder zweiten Zweig (B1, B2) definiert, wobei der Knoten eingerichtet ist, eine elektrische Ladung bis zu einem Pegel zu empfangen, der durch eine Coulomb-Barriere begrenzt ist, eine Potentialbarriereneinrichtung (MTJ, 2, 3), die zwischen dem Knoten und dem ersten bzw. zweiten Zweig gekoppelt ist, eine Takteinrichtung (Vcl), um eine Taktwellenform (φ1) vorzusehen, die ein Tunneln von Ladungsträgern zwischen dem Knoten (2) und den ersten oder zweiten Zweigen (B1, B2) verursacht, und eine Einrichtung (V2, V3) zum wahlweisen Ändern der relativen Pegel der Potentialbarriereneinrichtung in Abhängigkeit von den angelegten Steuersignalen, wodurch Ladungsträger selektiv bevorzugt zum Tunneln zwischen dem ersten oder dem zweiten Zweig und dem Knoten veranlaßt werden.

2. Vorrichtung gemäß Anspruch 1 umfassend einen Botensignaleingang (1) für den Knoten (2) und die Potentialbarriereneinrichtung (MTJ1) zwischen dem Eingang und dem Knoten.

3. Vorrichtung gemäß Anspruch 2 umfassend eine Einrichtung (Vcl, Cg) zum Anlegen der Taktwellenform (φ1) an den Knoten (2).

4. Vorrichtung gemäß einem der vorangegangenen Ansprüche umfassend eine Vielzahl von BDD-Logik-Elementen (BDD1), die aneinander gekoppelt sind, wobei jedes Element jeweils einen Satz aus zwei der Zweige, einen verbundenen Knoten und eine Potentialbarriereneinrichtung zwischen den zwei Zweigen und dem Knoten aufweist.

5. Vorrichtung gemäß Anspruch 4 umfassend eine Einrichtung zum Anlegen einer Vielzahl von Taktwellenformen (φ1, φ2, φ3, φ4) an die BDD-Logik-Elemente mit einer Phasendifferenz, um Ladungsträger dazu zu veranlassen, sich von Knoten zu Knoten der Logik-Elemente zu bewegen.

6. Vorrichtung gemäß einem der vorangegangenen Ansprüche, wobei die Potentialbarriereneinrichtung Mehrfachtunnelbarrieren-Konfigurationen (MTJ1, MTJ2, MTJ3) aufweist.

7. Vorrichtung gemäß Anspruch 6, wobei die Mehrfachtunnelbarrieren-Konfigurationen mit Seiten-Gate-Elektroden (6) versehen sind.

8. Vorrichtung gemäß Anspruch 7 umfassend eine Einrichtung zum Anlegen der Eingangssignale (X1, X2, X3) an die Seiten-Gate-Elektroden (61, 62, 63).

9. Vorrichtung gemäß einem der Ansprüche 6 bis 8, wobei die Einrichtung, die die Tunnelbarrieren-Konfiguration aufweist, einen leitenden Kanal (10) umfaßt, der aus einer δ-dotierten Schicht in einem Substrat (11) gebildet wurde, wobei der Kanal einen Bereich (12, 15) eingeschränkter Breite aufweist, der die Eigenschaften eines Mehrfachtunnelübergangs zeigt.

10. Vorrichtung gemäß Anspruch 9 umfassend eine Seiten-Gate-Einrichtung (13, 17), die benachbart zum eingeschränkten Bereich liegt.

11. Vorrichtung gemäß Anspruch 10, wobei die Seiten-Gate-Einrichtung eine Leiterbahn (17) aufweist, die über dem leitenden Kanal liegt.

12. Vorrichtung gemäß einem der vorangegangenen Ansprüche umfassend eine Ausgabeeinrichtung (A1, A2), die an die Blätter gekoppelt ist, um ein logisches Ausgangssignal vorzusehen.

13. Vorrichtung gemäß Anspruch 12, wobei die Ausgabeeinrichtung einen Verstärker aufweist.

## Revendications

1. Dispositif logique de diagramme de décision binaire (BDD) comprenant un moyen définissant une racine (R), des feuilles (L1, L2) pour fournir des sorties de données, des branches (B) pour acheminer des signaux messagers de la racine aux feuilles, et au moins un noeud (Ndi, 2) pour commuter des signaux entre une première et une seconde (B1, B2) des branches de manière sélective en fonction des signaux d'entrée appliqués (Xi), le noeud étant adapté pour recevoir la charge électrique à un niveau limité par le blocage de Coulomb, un moyen de barrière de potentiel (MTJ, 2, 3) couplé entre le noeud et les première et seconde branches respectivement, un moyen de cadencement (Vc1) pour fournir une forme d'onde de cadencement (φ1) qui provoque le passage par effet tunnel du porteur de charge entre le noeud (2) et les première et seconde branches (B1, B2), et un moyen (V2, V3) pour modifier les niveaux relatifs du moyen de barrière de potentiel de manière sélective en fonction des signaux de commande appliqués pour faire que les porteurs de charge circulent préférentiellement par effet tunnel entre la première ou la seconde branche et le noeud de manière sélective.

2. Dispositif selon la revendication 1, comprenant une entrée de signal messager (1) pour le noeud (2) et un moyen de barrière de potentiel (MTJ1) entre l'entrée et le noeud.

3. Dispositif selon la revendication 2, comprenant un moyen (Vcl, Cg) pour appliquer la forme d'onde de cadencement (φ1) au noeud (2).

4. Dispositif selon l'une quelconque des revendications précédentes, comprenant une pluralité d'éléments logiques BDD (BDD1) couplés les uns aux autres, chacun desdits éléments comprenant un jeu respectif de deux desdites branches, undit noeud associé et un moyen de barrière de potentiel entre les deux branches et le noeud.

5. Dispositif selon la revendication 4, comprenant un moyen pour appliquer une pluralité de formes d'onde de cadencement ($\varphi$1, $\varphi$2, $\varphi$3, $\varphi$4) aux éléments logiques BDD avec une différence de phase pour faire que les porteurs de charge se déplacent de noeud à noeud des éléments logiques.

6. Dispositif selon l'une quelconque des revendications précédentes, dans lequel le moyen de barrière de potentiel comprend de multiples configurations de barrière à effet tunnel (MTJ1, MTJ2, MTJ3).

7. Dispositif selon la revendication 6, dans lequel les multiples configurations de barrière à effet tunnel sont munies de grilles latérales (6).

8. Dispositif selon la revendication 7, comprenant un moyen pour appliquer lesdits signaux d'entrée (X1, X2, X3) aux grilles latérales (61, 62, 63).

9. Dispositif selon l'une quelconque des revendications 6 à 8, dans lequel le moyen fournissant la configuration de barrière à effet tunnel comprend un canal conducteur (10) qui a été formé à partir d'une couche dopée $\delta$ dans un substrat (11), le canal comprenant une zone (12, 15) de largeur rétrécie qui offre les caractéristiques d'une jonction tunnel multiple.

10. Dispositif selon la revendication 9, comprenant un moyen de grille latérale (13, 17) adjacent à la zone rétrécie.

11. Dispositif selon la revendication 10, dans lequel le moyen de grille latérale comprend une piste conductrice (17) qui recouvre le canal conducteur.

12. Dispositif selon l'une quelconque des revendications précédentes, comprenant un moyen de sortie (A1, A2) couplé aux feuilles pour fournir un signal logique de sortie.

13. Dispositif selon la revendication 12, dans lequel le moyen de sortie comprend un amplificateur.

**FIG. 1**
PRIOR ART

**FIG. 2**
PRIOR ART

FIG. 3

FIG. 4

FIG. 5

FIG. 6

FIG. 9

# FIG. 7

side gate

150nm

Si δ-doped layer

13

10

12

9

10

11

electron channel

GaAs substrate

10 nm

## FIG. 8

-10.0  0.0  10.0

Energy (meV)

FIG. 10

FIG. 11

FIG. 12

FIG. 13

FIG. 14

FIG. 15

FIG. 17

FIG. 16

FIG.18a

Al

18

10

11

δ-doped layer

GaAs substrate

FIG.18b

19a

16b

15

19

PMMA

18

10

11

16a

FIG.18c

17

Au

18

10

11

FIG. 18d

17

18

10

11

20b

20b

20a    20a

FIG. 18e

17

9

10

FIG. 19

9    17

220203 10KY X6.00K 5.00um